# EUROPEAN PATENT SPECIFICATION

(11) **EP 3 153 948 B1**
(45) Date of publication and mention of the grant of the patent: **28.09.2022**
(21) Application number: 15805753.9
(22) Date of filing: 03.06.2015
(51) Int. Cl.: G06F 3/041, G06F 3/01, B06B 1/06, H01L 41/053, H01L 41/08

(54) **VIBRATING DEVICE AND HAPTIC DEVICE**
VIBRIERENDE VORRICHTUNG UND HAPTISCHE VORRICHTUNG
DISPOSITIF VIBRANT ET DISPOSITIF HAPTIQUE

(30) Priority: 09.06.2014 JP 2014118332
(43) Date of publication of application: 12.04.2017
(73) Proprietor: Murata Manufacturing Co., Ltd., Nagaokakyo-shi, Kyoto 617-8555 (JP)
(72) Inventor: HASHIMOTO, Junichi, Nagaokakyo-shi Kyoto 617-8555 (JP)
(74) Representative: Reeve, Nicholas Edward
(86) International application number: PCT/JP2015/065983
(87) International publication number: WO 2015/190358

(56) References cited:
- JP-A- 2003 108 311
- JP-A- 2005 352 927
- JP-A- 2010 152 889
- JP-A- 2012 242 871
- US-A- 5 856 956
- US-A1- 2003 189 766
- US-A1- 2012 256 838
- US-A1- 2014 079 255

## Description

### Technical Field

The present invention relates to a vibrating device which vibrates a diaphragm by driving a piezoelectric film, and a tactile sense presenting device which transmits the vibration of the vibrating device as a tactile sense feedback of a touch operation to a user.

### Background Art

A vibrating device which vibrates a diaphragm by driving a piezoelectric film is used in a flat speaker or a haptics device (tactile sense presenting device) (see, for example, WO2012/157691).

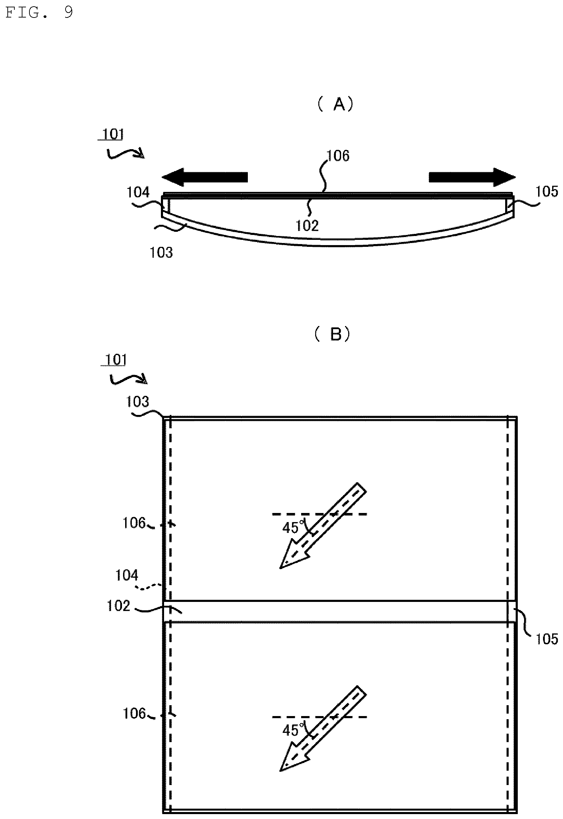

FIG. 9(A) is a side view of a vibrating device 101 employing a conventional configuration, and FIG. 9(B) is a back vide of the vibrating device 101. The vibrating device 101 includes a piezoelectric film 102, a diaphragm 103 and frame members 104 and 105. The diaphragm 103 and the piezoelectric film 102 have rectangular shapes elongated in a length direction and a width direction when seen from a thickness direction. The piezoelectric film 102 is cut out from a PLLA (poly-L-lactic acid) film subjected to extension processing in a direction of 45° which is the length direction with respect to an extension direction indicated by arrows in FIG. 9(B). The piezoelectric film 102 is cut out in this way to generate a stretch and contraction in the length direction with application of a voltage. The frame members 104 and 105 are provided at both ends of the piezoelectric film 102 in the length direction. Vicinities of both ends of the diaphragm 103 in the length direction are connected to the piezoelectric film 102 with the frame members 104 and 105 interposed between the both ends of the diaphragm 103. Further, the diaphragm 103 warps such that a vicinity of center of the diaphragm 103 in the length direction is apart from the piezoelectric film 102, and the frame members 104 and 105 pull the piezoelectric film 102 to an outside of the length direction via the frame members 104 and 105. In this vibrating device 101, the piezoelectric film 102 vibrates in the length direction when an alternating electric field is applied to the piezoelectric film 102, and a warp amount of the diaphragm 103 fluctuates a warp amount accompanying this vibration.

When the haptics device (tactile sense presenting device) is configured by using the vibrating device illustrated in FIG. 9, a pressing force in the thickness direction is transmitted to the diaphragm in response to a touch operation. Then, the diaphragm is pushed by a pressing force, and the diaphragm flattens. When the diaphragm flattens, the diaphragm and the piezoelectric film become parallel, and, even when the piezoelectric film is vibrated in the length direction, the diaphragm hardly warps.

Hence, it is difficult to give a tactile sense feedback to the user. To prevent the diaphragm from being pushed and flattened, the diaphragm may be made thick and rigidity of the diaphragm may be improved.

However, in this case, the warp amount of the diaphragm becomes small and it is difficult to give a tactile sense feedback to the user.

Published US patent application US2014/079255A1 in the name of the present applicant, discloses a plane speaker where, on one of the main surfaces of an exciter film, there are placed piezoelectric films which are expanded and contracted by sound releasing driving signals. An oscillation plate is secured to the excited film through frame members. The oscillation plate has a flat-plate shape and is secured to the exciter film while having a warped shape such that it is gradually spaced further away from the exciter film, with decreasing distance from the secured ends to a center area, when viewed at a side surface. This realizes a state where the exciter film is pulled outwardly with respect to the secured ends due to bending stresses therein. If sound-releasing driving signals are applied to the piezoelectric films in this state, the exciter film contracts and expands along with the expansion and contraction of the piezoelectric films, thereby causing the oscillation plate to oscillate.

Published US patent application US2012/256838A1 discloses a touch panel, more specifically a piezoresistive type touch panel and a method of manufacturing thereof. The method comprising manufacturing a polymer membrane in which a piezoresistive type film pattern, of which resistance varies with applied pressure, is embedded; manufacturing a spacer layer and attaching one side of the spacer layer to a surface of the polymer membrane; and then attaching a bottom substrate to the other side of the spacer layer.

Published US patent application US5856956A discloses a piezoelectric-acoustic transducer having a hollow case provided with a sound hole. A piezoelectric actuator is disposed inside this case that has one end fixed to the case and that bends in the direction of the thickness of the case when voltage is applied. A diaphragm is secured to one portion of the piezoelectric actuator and is positioned at a distance from the piezoelectric actuator in the direction of the thickness of the case.

Published US patent application US2003/189766A1 discloses an optical system or apparatus such as a lens system capable of focus control and a variable-focus lens, which has reduced power consumptions, that ensures noiseless operation and fast response and contributes to cost reductions for the reason of simplified structure.

We have appreciated that it would be desirable to provide a vibrating device and a tactile sense presenting device which can warp a diaphragm in a thickness direction from a flat state and can easily increase a warp amount of the diaphragm.

### SUMMARY OF THE INVENTION

The invention is set out by the independent claim, preferred embodiments are defined in the dependent claims. A vibrating device according to the present invention includes: a diaphragm which is configured to warp in a thickness direction; a film, part of which has a property that the film causes vibration in a planar direction of the film when electrically driven, which is connected to a first end of the diaphragm at a first connection position and to a second opposing end of the diaphragm at a second connection position, and which is stretched in a direction crossing the diaphragm from the first connection position to the second connection position, such that the planar vibration of the film causes the warping in a thickness direction of the diaphragm; and a spacer positioned between the diaphragm and the film which is configured to secure a gap between the diaphragm and the film at a position apart from the first and second connection positions.

According to this configuration, the spacer is provided, so that, irrespectively of a state of the diaphragm, the film is stretched in the direction crossing the diaphragm and a gap between the diaphragm and the film is maintained. Consequently, it is possible to reliably warp the diaphragm in the thickness direction by driving the film even in a flat state of the diaphragm. Further, even when the diaphragm is made thin and less rigid, a gap between the diaphragm and the film is not crashed. Consequently, it is possible to make the diaphragm thin and less rigid and increase the warp amount of the diaphragm.

The film may be connected to the second opposing end of the diaphragm via a support member.

The first connection position may be located in the vicinity of the first end of the diaphragm, and the second connection position may be located in the vicinity of the second opposing end of the diaphragm.

The spacer is preferably in contact with the diaphragm and the film at all times. According to this configuration, the spacer can be sandwiched between and held by the diaphragm and the film.

The spacer preferably includes a base portion which is provided at a side of the film, and a plurality of protrusion portions which is provided at a side of the diaphragm and protrudes in a thickness direction from the base portion. According to this configuration, it is possible to reduce a contact area between the diaphragm and the spacer. Consequently, it is possible to prevent attenuation of vibration when the diaphragm is pushed by a finger or the like above the spacer.

The spacer is preferably provided at or near the center of the vibrating device in a length direction orthogonal to the thickness direction.

A plurality of the spacers are preferably aligned in the length direction orthogonal to the thickness direction.

Preferably the diaphragm causes such a harmonic that a contact position with the spacer serves as a node of vibration of the diaphragm, and the harmonic can be set to an adequate frequency according to the number and positions of spacers. Generally, a frequency of vibration which is good as a tactile sense feedback for a finger (which means high sensitivity) is 100 Hz to 300 Hz. Consequently, a vibrating device whose resonance frequency is less than 100 Hz can adjust the harmonic of the vibration caused by the diaphragm to a frequency of 100 Hz to 300 Hz by adjusting the numbers and the positions of the spacers.

The diaphragm may have a flat shape in a state where the film does not cause the inverse piezoelectric effect. Consequently, it is possible to use the vibrating device for a wide range of use.

The film may be a piezoelectric film, a composite film or an electroactive film.

The film may include a chiral polymer film or a polyvinylidene fluoride film.

Further, a tactile sense presenting device according to the present invention includes: the vibrating device; a detecting unit which is attached to the diaphragm and detects a touch operation; and a control unit which, when the detecting unit detects the touch operation, applies a drive voltage to the piezoelectric film.

The tactile sense presenting device employing such a configuration can present a tactile sense feedback to an operator by vibrating the diaphragm to reliably warp in the thickness direction even when the diaphragm is flattened by a pressing force accompanying a touch operation. According to the present invention, the vibrating device and the tactile sense presenting device can reliably warp the diaphragm in the thickness direction from a flat state of the diaphragm.

### BRIEF DESCRIPTION OF DRAWINGS

FIG. 1 is a perspective view of and a plan view of a bottom surface side of a tactile sense presenting device according to a first embodiment.
FIG. 2 is a perspective view of a spacer according to the first embodiment.
FIG. 3 is a side view illustrating a vibration mode of a vibrating device according to the first embodiment.
FIG. 4 is a side view of a vibrating device according to a second embodiment.
FIG. 5 is a perspective view and a side view of a vibrating device according to a third embodiment.
FIG. 6 is a perspective view and a side view of a vibrating device according to a fourth embodiment.
FIG. 7 is a side view illustrating a vibration mode of a harmonic produced in the vibrating device according to the third and fourth embodiments.
FIG. 8 is a perspective view and a side view of a vibrating device according to a fifth embodiment.
FIG. 9 is a view for explaining a conventional structure of a vibrating device.

### DETAILED DESCRIPTION OF EXAMPLE EMBODIMENTS

A plurality of examples for carrying out the present invention will be described by using some specific examples with reference to the drawings. Each embodiment is exemplary, and components described in different embodiments may be naturally partially replaced or combined.

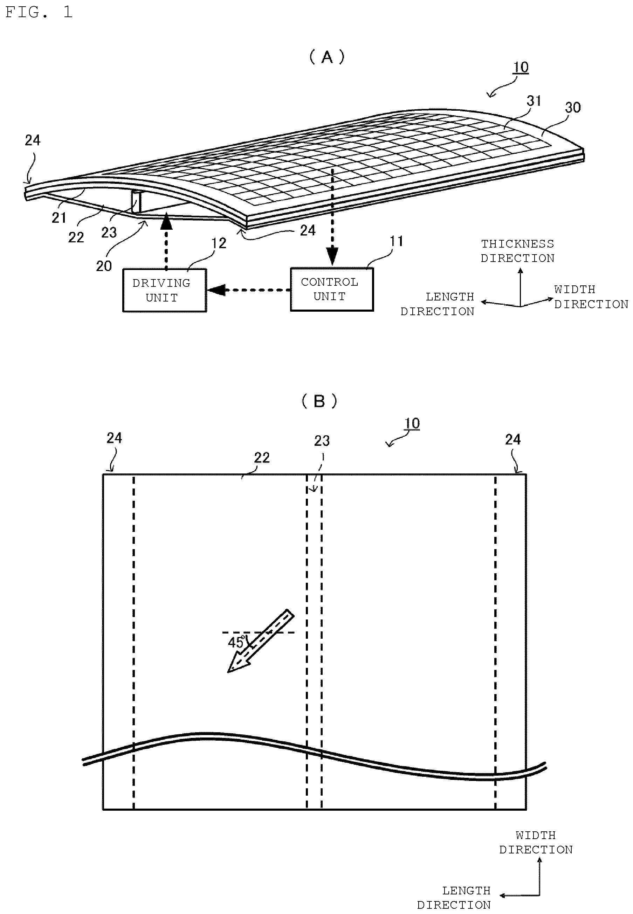

FIG. 1(A) is a perspective view of a tactile sense presenting device 10 according to the first embodiment of the present invention. FIG. 1(B) is a plan view illustrating the tactile sense presenting device 10 from a bottom surface side.

The tactile sense presenting device 10 composes a keyboard of a touch sensor type. The tactile sense presenting device 10 includes a control unit 11, a driving unit 12, a vibrating device 20 and a touch panel 30. In addition, the tactile sense presenting device 10 may include a switch of a sheet shape such as a membrane switch in place of the touch panel 30, yet a key position to be displayed or an indication can be arbitrarily changed by using the touch panel 30.

The vibrating device 20 and the touch panel 30 are thin in a thickness direction, and are stacked in the thickness direction. The touch panel 30 is disposed at a top panel side in the thickness direction with respect to the vibrating device 20. The touch panel 30 includes a plurality of touch sensors 31 exposed on the top panel of the tactile sense presenting device 10. A plurality of touch sensors 31 is disposed at positions meeting a key alignment of the keyboard. Each touch sensor 31 outputs a detection signal to the control unit 11 when detecting a user's touch operation. Each touch sensor 31 corresponds to a touch detecting unit recited in the claims.

The control unit 11 outputs a control signal to the driving unit 12 when receiving an input of the detection signal from one of the touch sensors 31. The driving unit 12 outputs a drive voltage to the vibrating device 20 when receiving an input of the control signal from the control unit 11.

The vibrating device 20 includes a diaphragm 21, a piezoelectric film 22 and a spacer 23.

The diaphragm 21 is made of an elastically deformable material such as an acrylic resin PMMA. In addition, other materials such as a metal plate, PET, polycarbonate (PC), PLLA and glass may be used for the diaphragm 21. The diaphragm 21 is disposed at the top panel side in the thickness direction with respect to the piezoelectric film 22. The diaphragm 21 has a rectangular shape when seen from the thickness direction, and has short sides which lie along a length direction and long sides which lie along a width direction. Further, the diaphragm 21 is curved protruding toward the top plane side in the thickness direction and recessing toward the bottom surface side in the thickness direction when seen from the width direction. The top panel of the diaphragm 21 is jointed to the touch panel 30 with an adhesive or the like interposed therebetween. The diaphragm 21 has a flat shape curved when seen from the width direction, and therefore the touch panel 30 also has a shape curved when seen from the width direction similar to the diaphragm 21.

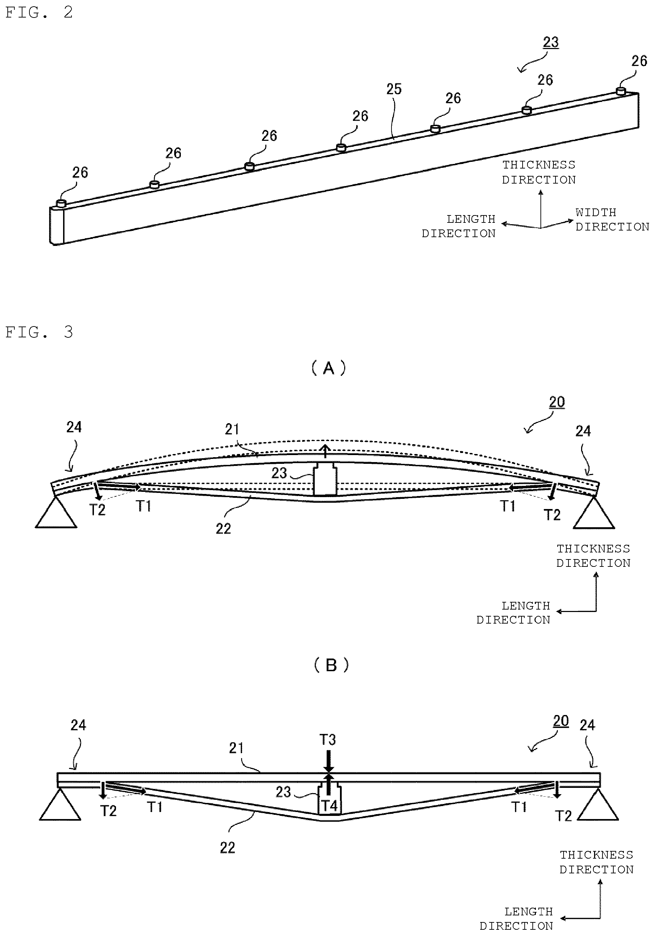

The piezoelectric film 22 has a property that the piezoelectric film 22 causes vibration in a planar direction when electrically driven, and corresponds to a "film" recited in the claims. The piezoelectric film 22 is composed by providing electrodes which are not illustrated to both of entire principal surfaces of the film made of a piezoelectric material having piezoelectricity. The piezoelectric material of the piezoelectric film 22 is, for example, poly-L-lactic acid (PLLA) which is chiral polymers, and is desirably polyvinylidene fluoride (PVDF). When being composed of PLLA, the piezoelectric film 22 is cut out from a film extended in a main extension direction indicated by an outlined arrow in FIG. 2(B) in a direction of approximately 45° which is the length direction with respect to the main extension direction.

Consequently, the piezoelectric film 22 can have piezoelectricity for allowing the piezoelectric film 22 to stretch and contract in the length direction.

In addition to the piezoelectric film, optional films may be adopted for the "film" as long as the films have the property that the films cause vibration in the planar direction when electrically driven. For example, the "film" can be composed as a composite film or an electroactive film. The electroactive film is a film which causes a stress or displacement in the planar direction when electrically driven. The composite film is a film formed by adding a piezoelectric film, the electroactive film or piezoelectric ceramics to a base material such as a resin film. The composite film or the electroactive film can be composed of a piezoelectric film, piezoelectric ceramics, an electrostriction film, an electret film, an electrically driven elastomer, a urethane rubber, a silicon rubber, a fluororubber, a nitrile rubber, a diene rubber or a liquid crystal elastomer.

The piezoelectric film 22 is disposed at the bottom surface side in the thickness direction with respect to the diaphragm 21. The piezoelectric film 22 is connected to vicinities of both ends of the diaphragm 21 in the length direction at the bottom surface side of the diaphragm 21 curved in a recess shape. Both ends of the piezoelectric film 22 and the diaphragm 21 in the length direction are fixed ends 24. That is, the piezoelectric film 22 is stretched between the two fixed ends 24. The vibrating device 20 and the tactile sense presenting device 10 are supported on an installation surface of a table or the like near the two fixed ends 24.

The piezoelectric film 22 is stretched at the fixed ends 24 in a direction crossing a bottom surface of the diaphragm 21. Hence, a tensile force transmits from the piezoelectric film 22 to the diaphragm 21, and therefore the diaphragm 21 elastically deforms warping in the thickness direction. Thus, the diaphragm 21 and the piezoelectric film 22 compose the vibrating device 20 which is formed in a bow shape when seen from the width direction. Further, the spacer 23 is provided in a gap between the diaphragm 21 and the piezoelectric film 22 and near a center between the diaphragm 21 and the piezoelectric film 22 in the length direction to secure a gap of a predetermined interval between the diaphragm 21 and the piezoelectric film 22.

FIG. 2 is a perspective view of the spacer 23.

The spacer 23 is made of metal, PET or polycarbonate (PC), for example. The spacer 23 preferably has high rigidity to prevent attenuation of vibrations of the diaphragm 21 and the piezoelectric film 22, and may be made of a material of a higher elastic modulus than those of the diaphragm 21 and the piezoelectric film 22. The spacer 23 is sandwiched between and held by the diaphragm 21 and the piezoelectric film 22, and is preferably fixed to at least one of the diaphragm 21 and the piezoelectric film 22 with an adhesive or the like interposed therebetween. Further, the spacer 23 includes a base portion 25 and a plurality of protrusion portions 26. The base portion 25 is a portion which is provided at the side of the piezoelectric film 22 and is elongated in the width direction. A plurality of protrusion portions 26 is portions which are provided at the side of the diaphragm 21, and is provided to protrude from a top panel of the base portion 25 to the thickness direction. By providing the protrusion portions 26 at a top panel side of the spacer 23, it is possible to reduce a contact area between the diaphragm 21 and the spacer 23. Consequently, even when a finger or the like presses the vicinity of the center of the diaphragm 21 in the length direction, i.e., a portion directly above the spacer 23, it is possible to prevent significant attenuation of vibration. In addition, the protrusion portions 26 are more preferably provided at positions facing a frame portion between the touch sensors 31 on the touch panel 30.

FIG. 3(A) is a side view illustrating a vibration mode of the vibrating device 20 in a state where a pressing force is not applied.

The spacer 23 is disposed near the center between the piezoelectric film 22 and the diaphragm 21 in the length direction, and is in contact with a lower surface of the diaphragm 21 and an upper surface of the piezoelectric film 22. A dimension of the spacer 23 in the thickness direction is set to a slightly larger dimension than an interval near the center between the diaphragm 21 and the piezoelectric film 22 in the length direction in case where the spacer 23 is not provided. Hence, when the piezoelectric film 22 is not driven, the spacer 23 pushes the piezoelectric film 22 downward in the thickness direction, and the piezoelectric film 22 is curved protruding downward at a contact position with the spacer 23.

When an alternating electric field is applied to the piezoelectric film 22 to drive the film 22, the piezoelectric film 22 repeatedly contracts in the length direction. Then, a tensile force T1 transmitting from the piezoelectric film 22 to the diaphragm 21 cyclically increases. Thus, a force component T2 of the tensile force T1 in a direction vertical to a surface of the fixed end 24 also cyclically increases. Therefore, as indicated by dotted lines in FIG. 3(A), a warp amount of the diaphragm 21 cyclically increases. That is, the vicinity of the center of the diaphragm 21 in the length direction is cyclically displaced upward. Thus, the spacer 23 is cyclically displaced upward to maintain a state where the spacer 23 keeps contact with the diaphragm 21, and an angle at which the piezoelectric film 22 is curved near the center in the length direction is cyclically reduced.

FIG. 3(B) is a side view for explaining a vibration mode of the vibrating device 20 in a state where a pressing force produced by a touch operation or the like is applied.

In a state where a pressing force T3 of the finger or the like which performs the touch operation is applied to the diaphragm 21 and the diaphragm 21 is pushed in a roughly flat shape, an elastic force of the vibrating device 20 produces a reaction force T4 with respect to the pressing force T3 and works on the finger or the like. In this state, the spacer 23 is pushed downward together with the diaphragm 21, and the piezoelectric film 22 bends more compared to a case where the pressing force T3 is not applied. That is, even when the pressing force T3 is applied to the diaphragm 21 and the diaphragm 21 is pushed in a roughly flat shape, the spacer 23 prevents the gap between the diaphragm 21 and the piezoelectric film 22 from being crashed, and the piezoelectric film 22 is kept in a state where the piezoelectric film 22 is stretched in the direction crossing the surface of the fixed end 24. Consequently, even when the diaphragm 21 is in a flat state, the force component T2 of the tensile force T1 works in a direction vertical to the surface of the fixed end 24.

Hence, even when the alternating electric field is applied to the piezoelectric film 22 and is driven in this state, the tensile force T1 transmitting from the piezoelectric film 22 to the diaphragm 21 and the force component T2 of the tensile force T1 cyclically increase, and the diaphragm 21 cyclically warps significantly. Thus, the reaction force T4 transmitting from the diaphragm 21 to the finger or the like which pushes the diaphragm 21 cyclically fluctuates, so that it is possible to present a tactile sense feedback to a user who performs the touch operation. Consequently, even if a key position displayed on the touch panel 30 is arbitrarily changed, and this key position is touched, the user can have a clicking feeling, so that it is possible to improve operability and an operational feeling of the touch keyboard.

Thus, in the tactile sense presenting device 1 and the vibrating device 20, the spacer 23 prevents the gap between the diaphragm 21 and the piezoelectric film 22 from being crushed.

Consequently, it is possible to make the diaphragm 21 thin, suppress rigidity of the diaphragm 21 and make the warp amount of the diaphragm 21 large compared to the conventional technique.

In addition, in the present embodiment, both ends of the diaphragm 21 and the piezoelectric film 22 in the length direction are connected as the fixed ends 24, so that it is possible to suppress the number of members which compose the vibrating device. In this regard, the tactile sense presenting device and the vibrating device according to the present invention may employ different configurations from the above configurations.

For example, only one end sides of the diaphragm and the piezoelectric film in the length direction may be directly connected, and the other end sides in the length direction may be connected with a support member interposed therebetween.

Further, in the present embodiment, the piezoelectric film 22 which is a single layer is configured to be stretched on the diaphragm 21.

However, the piezoelectric film 22 may be pasted on a filter (exciter film) which is a base material such as a resin film, and stretched on the diaphragm 21 to compose the tactile sense presenting device and the vibrating device according to the present invention. Further, piezoelectric ceramics may be added to the exciter film and the exciter film is stretched on the diaphragm 21 to compose the tactile sense presenting device and the vibrating device according to the present invention. In this case, a pair of exciter films may be prepared, one end of each exciter film may be connected to the piezoelectric ceramics, and the other end of each exciter film may be connected to the diaphragm 21. Further, a plurality of pairs of exciter films may be prepared, and configured to be connected with one piezoelectric ceramics.

Furthermore, in the present embodiment, the spacer 23 is provided with the base portion 25 and the protrusion portions 26, yet, for example, the spacer 23 may have a shape without the protrusion portions 26. In this regard, providing the protrusion portions 26 can reduce a contact area between the spacer 23 and the diaphragm 21. When the contact area between the spacer 23 and the diaphragm 21 is smaller, the spacer 23 is prevented from constraining vibration of the diaphragm 21 and the diaphragm 21 can be vibrated better. Further, the protrusion portions 26 are not limited to columnar shapes illustrated in FIG. 2 and may have other shapes such as semispherical shapes or conical shapes.

Furthermore, additionally, the protrusion portions 26 may have a blade back shape (blade shape) protruding toward the diaphragm 21 in the thickness direction and stretching in an intra-plane direction. Still further, the protrusion portions 26 may have cross sections of polygonal shapes such as quadrangular prism shapes. Moreover, the base portion 25 of the spacer 23 may have a shape different from a cuboid shape.

Besides, a configuration where, even when the piezoelectric film 22 is not driven, the spacer 23 is in contact with the diaphragm 21 and the piezoelectric film 22 and a tension is applied from the spacer 23 to the piezoelectric film 22 has been described in the present embodiment.

However, the present invention is not limited to this example. For example, the spacer 23 may be set to the substantially same height as the interval between the diaphragm 21 and the piezoelectric film 22 in case where the piezoelectric film 22 is not driven. In this case, even in a state where the spacer 23 is in contact with the piezoelectric film 22 and the piezoelectric film 22 when the piezoelectric film 22 is not driven, a tension is not applied from the spacer 23 to the piezoelectric film 22.

Consequently, compared to a case where the tension is applied from the spacer 23 to the piezoelectric film 22 at all times, it is possible to reduce a load applied to the piezoelectric film 22 and prevent shape deterioration and characteristics deterioration of the piezoelectric film 22.

Next, a vibrating device according to a second embodiment of the present invention will be described.

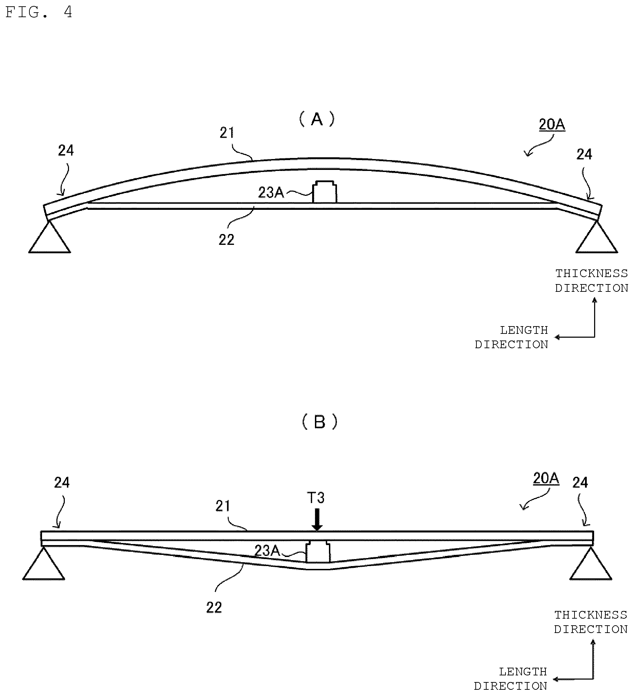

FIG. 4(A) is a side view illustrating a state where a pressing force is not applied to a vibrating device 20A according to the second embodiment. The vibrating device 20A includes a diaphragm 21, a piezoelectric film 22 and a spacer 23A. The spacer 23A is set to a dimension smaller than an interval between the diaphragm 21 and the piezoelectric film 22 in case where the spacer 23A is not provided, and is fixed to the piezoelectric film 22 (or diaphragm 21) via an adhesive or the like. Hence, in a state where the pressing force is not applied to the vibrating device 20A, the spacer 23A is not in contact with the diaphragm 21 and the piezoelectric film 22 is flat.

FIG. 4(B) is a side view illustrating a state where the pressing force is applied to the vibrating device 20A according to the second embodiment. In a state where a relatively great pressing force T3 is applied from a finger or the like which performs a touch operation to the diaphragm 21 and the diaphragm 21 is pushed in a roughly flat shape, the spacer 23A is in contact with both of the diaphragm 21 and the piezoelectric film 22, and pushes the piezoelectric film 22 downward. Thus, the piezoelectric film 22 is curved protruding downward at a contact position with the spacer 23A. Hence, the spacer 23 prevents the gap between the diaphragm 21 and the piezoelectric film 22 from being crashed, and, even when the diaphragm 21 flattens by the pressing force T3, the piezoelectric film 22 is kept in a state where the piezoelectric film 22 is stretched in the direction crossing a surface of a fixed end 24.

Consequently, the vibrating device 20A can also vibrate the diaphragm 21 repeatedly warping by driving the piezoelectric film 22 in a state where the pressing force T3 is applied to the diaphragm 21 from the finger or the like which performs a touch operation to push the diaphragm 21 in a roughly flat shape. Consequently, even when the tactile sense presenting device is composed by using the vibrating device 20A, it is possible to present a tactile sense feedback to a user who performs the touch operation.

Further, according to a configuration where the spacer is not in contact with the diaphragm at a normal time as in the present embodiment, when the finger or the like which performs the touch operation touches the diaphragm or the touch panel, vibration of the diaphragm is not constrained by the spacer.

Consequently, a time taken by the vibration of the diaphragm to rise from zero to a desired amplitude is short. Consequently, it is possible to give a more reliably tactile sense feedback to an operator who performs the touch operation.

Next, a vibrating device according to a third embodiment of the present invention will be described.

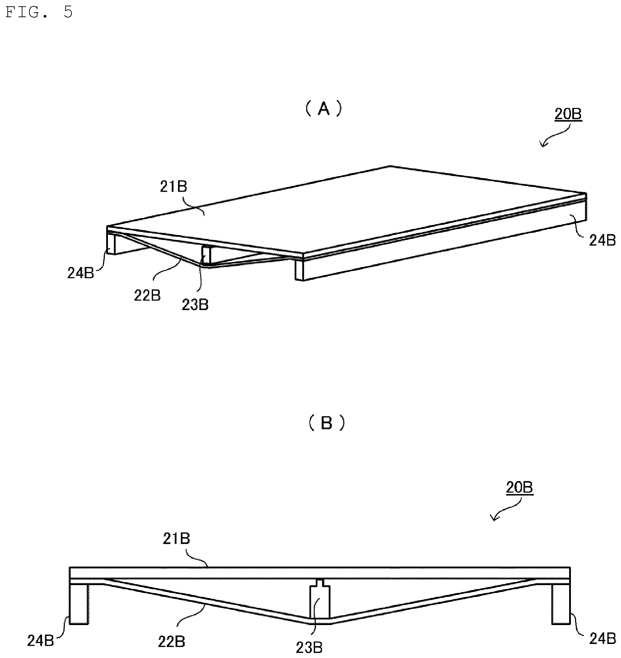

FIG. 5(A) is a perspective view of a vibrating device 20B according to the third embodiment, and FIG. 5(B) is a side view of the vibrating device 20B according to the third embodiment.

The vibrating device 20B includes a diaphragm 21B, a piezoelectric film 22B, a spacer 23B and fixed portions 24B. Vicinities of both ends of the diaphragm 21B and the piezoelectric film 22B in a length direction are connected with each other, and an initial shape of the diaphragm 21B and a tensile force of the piezoelectric film 22B are set such that the diaphragm 21B maintains a flat shape without curving in a state where the both ends are connected. More specifically, an initial shape of the diaphragm 21B in a state where the diaphragm 21B is not connected with the piezoelectric film 22B is formed in a curved shape protruding downward in advance. Further, the tensile force of the piezoelectric film 22B is set such that the tensile force applied by the piezoelectric film 22B and an external force applied by the spacer 23B deform the diaphragm 21B in a flat shape.

Near the both ends of the diaphragm 21B and the piezoelectric film 22B which are connected, the fixed portions 24B are provided protruding downward in a thickness direction of the vibrating device 20B. The fixed portions 24B are supported on an installation surface of a table or the like, and prevent the diaphragm 21B and the piezoelectric film 22B from directly contacting the installation surface.

In the vibrating device 20B employing such a configuration, too, the spacer 23B is disposed near the center between the piezoelectric film 22B and the diaphragm 21B in the length direction, and comes into contact with a lower surface of the diaphragm 21B and an upper surface of the piezoelectric film 22B to secure a gap of a predetermined interval between the diaphragm 21B and the piezoelectric film 22B. Hence, the spacer 23B pushes the piezoelectric film 22B downward in the thickness direction, and the piezoelectric film 22B is curved protruding downward at a contact position with the spacer 23B.

Thus, even when the diaphragm 21B is in a flat state, the piezoelectric film 22B is stretched in a direction crossing a surface of the diaphragm 21B. Consequently, the diaphragm 21B cyclically warps by driving the piezoelectric film 22B, so that it is possible to present a tactile sense feedback to a user who performs a touch operation. Thus, by providing the spacer 23B, the vibrating device 20B can warp the diaphragm 21B even when it is not in a curved shape. Consequently, it is possible to increase the degree of freedom of the shape of the diaphragm 21B.

Next, a vibrating device according to a fourth embodiment of the present invention will be described.

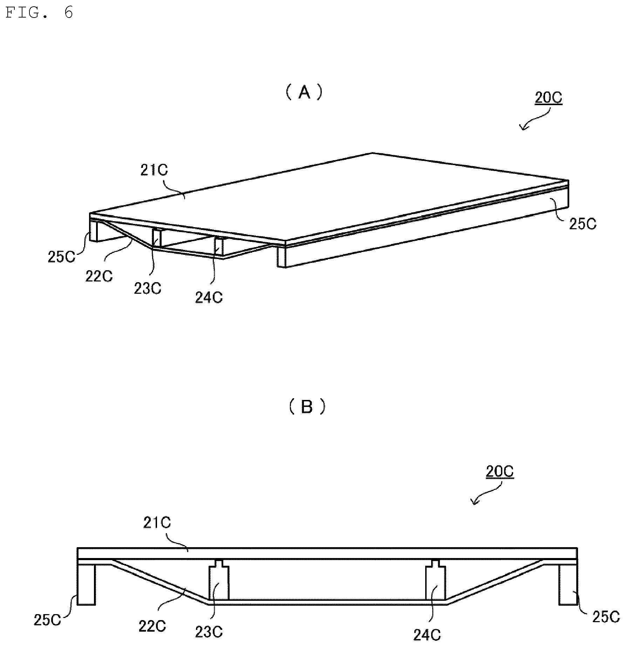

FIG. 6(A) is a perspective view of a vibrating device 20C according to the fourth embodiment, and FIG. 6(B) is a side view of the vibrating device 20C according to the fourth embodiment.

The vibrating device 20C includes a diaphragm 21C, a piezoelectric film 22C, spacers 23C and 24C and fixed portions 25C. Vicinities of both ends of the diaphragm 21C and the piezoelectric film 22C in a length direction are connected with each other, and an initial shape of the diaphragm 21C and a tensile force of the piezoelectric film 22C are set such that the diaphragm 21C maintains a flat shape without curving in a state where the both ends are connected. Near the both ends of the diaphragm 21C and the piezoelectric film 22C which are connected, the fixed portions 25C are configured to protrude downward in a thickness direction of the vibrating device 20C. The spacers 23C and 24C are aligned at predetermined intervals in the length direction of the vibrating device 20C, and come into contact with a lower surface of the diaphragm 21C and an upper surface of the piezoelectric film 22C to secure a predetermined interval between the diaphragm 21C and the piezoelectric film 22C. Hence, the piezoelectric film 22C is pushed downward in a thickness direction and is curved by the spacers 23C and 24C.

The diaphragm 21B is in a flat state in this vibrating device 20C, too, and the piezoelectric film 22B is stretched in a direction crossing a surface of the diaphragm 21C. Consequently, the diaphragm 21C cyclically warps by driving the piezoelectric film 22C, so that it is possible to present a tactile sense feedback to a user who performs a touch operation.

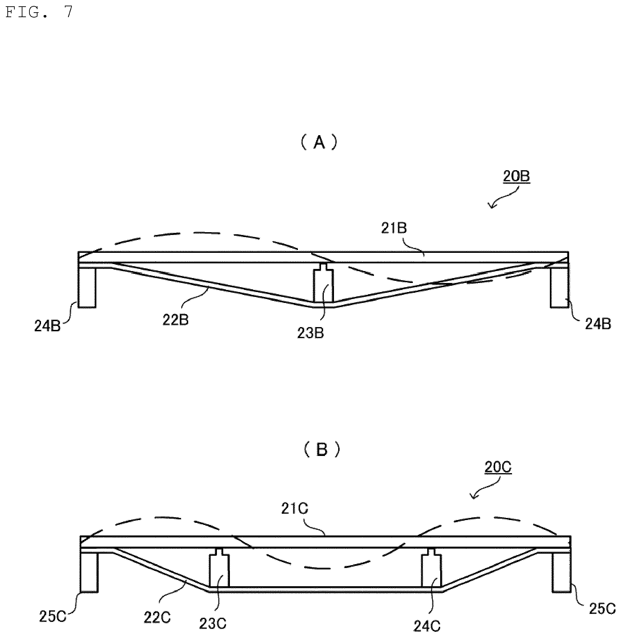

FIG. 7 is a view for explaining vibrations caused by a vibrating device 20B according to the third embodiment and the vibrating device 20C according to the fourth embodiment.

The vibrating device 20B and the vibrating device 20C have resonance frequencies determined according to dimensions of diaphragm 21B and 21C in the length direction. Hence, when a drive signal of a frequency matching with the resonance frequencies is applied to the vibrating device 20B and the vibrating device 20C, such vibrations that the vicinity of centers of the vibrating device 20B and the vibrating device 20C in the length direction serves as antinodes of vibration and vicinities of both ends of the vibrating device 20B and the vibrating device 20C in the length direction are fixed ends occur. Further, such a harmonic that contact positions with spacers 23B, 23C and 24C in the diaphragms 21B and 21C serve as nodes of the vibration is superimposed on the vibrations of the diaphragms 21B and 21C.

As illustrated in FIG. 7(A), the spacer 23B is in contact with the vicinity of the center of the diaphragm 21B in the length direction, so that the vibrating device 20B causes vibration of such a harmonic that this contact position serves as a node of the vibration. That is, vibration of a second harmonic whose 1 wavelength is the dimension of the diaphragm 21B in the length direction is superimposed on the vibration of the vibrating device 20B.

Meanwhile, as illustrated in FIG. 7(B), the spacers 23C and 24C are aligned at an appropriate interval in the length direction of the diaphragm 21C, so that the vibrating device 20C causes vibration of such a harmonic that connection positions with the spacers 23C and 24C serve as nodes of the vibration. That is, the vibration of a third harmonic whose 1.5 wavelength is the dimension of the diaphragm 21C in the length direction is superimposed on the vibration of the vibrating device 20C.

Hence, the vibrating device 20B according to the third embodiment and the vibrating device 20C according to the fourth embodiment differ in frequencies of harmonics produced by the diaphragms 21B and 21C even when the dimensions of the diaphragms 21B and 21C in the length direction are equal. Generally, a frequency of vibration which is good as a tactile sense feedback for a finger (which means high sensitivity) is 100 Hz to 300 Hz.

Consequently, when resonance frequencies of the diaphragms 21B and 21C are frequencies lower than 100 Hz, it is possible to adjust the harmonics of the vibrations caused by the diaphragms 21B and 21C to frequencies of 100 Hz to 300 Hz by adjusting the numbers and the positions of the spacers. Consequently, even when the resonance frequencies of the diaphragms 21B and 21C are frequencies lower than 100 Hz, it is possible to provide a good tactile sense feedback of a finger or the like.

Next, a vibrating device according to a fifth embodiment of the present invention will be described.

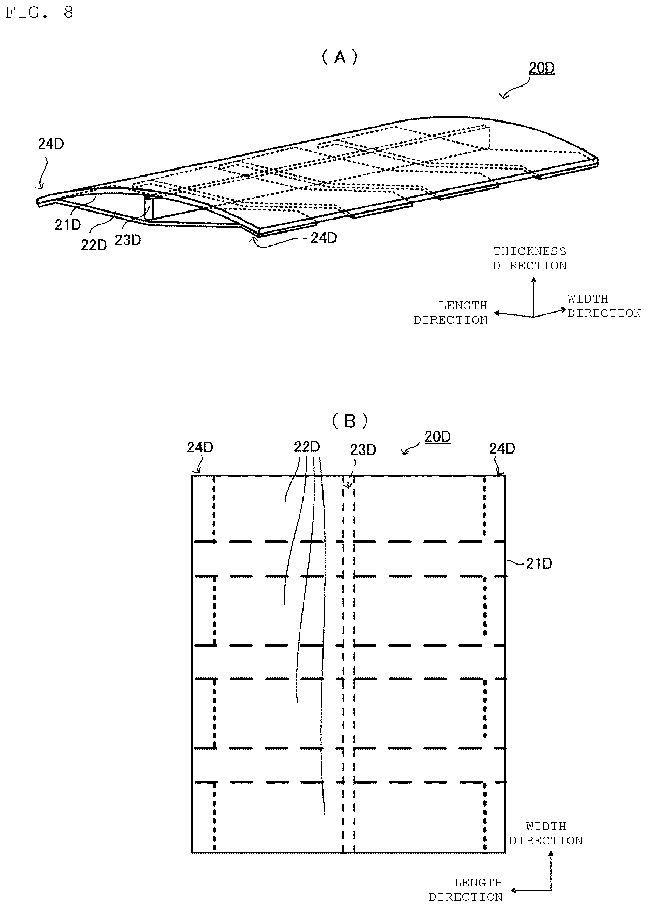

FIG. 8(A) is a perspective view of a vibrating device 20D according to the fifth embodiment, and FIG. 8(B) is a side view of the vibrating device 20D according to the fifth embodiment.

The vibrating device 20D includes a diaphragm 21D, a plurality of piezoelectric films 22D and a spacer 23D. A plurality of piezoelectric films 22D has stripe shapes whose dimensions in a width direction are short and whose dimensions in a length direction are long, and are aligned in the width direction in parallel to each other. A plurality of piezoelectric films 22D has the substantially same dimension in the length direction as that of the diaphragm 21D, and is provided with fixed ends 24D which are connected with the diaphragm 21D, near both ends in the length direction. The spacer 23D is in contact with a lower surface of the diaphragm 21D and upper surfaces of a plurality of piezoelectric films 22D, extends in the width direction over a plurality of piezoelectric films 22D and secures a predetermined interval between the diaphragm 21D and a plurality of piezoelectric films 22D. Hence, a plurality of piezoelectric films 22D is pushed downward in a thickness direction and is curved by the spacer 23D.

In the vibrating device 20D, the shape of each piezoelectric film 22D is a strip shape which is long in the length direction. Therefore, when driven, each piezoelectric film 22D stretches or contracts the most in the length direction. Consequently, by vibrating the diaphragm 21D by using a plurality of these piezoelectric films 22D, it is possible to effectively vibrate the diaphragm 21D. Further, the vibrating device 20D is also provided with the spacer 23D similar to each of the above-described embodiments, so that it is possible to vibrate the diaphragm 21D even in a state where the diaphragm 21D is pushed. Consequently, even when the tactile sense presenting device is composed by using the vibrating device 20A, it is possible to present a tactile sense feedback to a user who performs the touch operation.

In addition, when a plurality of piezoelectric films is provided as in the present embodiment, a single spacer may be disposed across a plurality of piezoelectric films as described above, and, in addition, a plurality of shorter spacers may be individually disposed on piezoelectric films, respectively. By disposing a plurality of spacers on a plurality of piezoelectric films, it is possible to adjust a tension to be applied to each piezoelectric film, and more effectively vibrate the diaphragm, too.

Further, similar to the configuration illustrated in FIG. 6, according to the configuration according to the present embodiment, too, a plurality of spacers may be aligned in the length direction of each piezoelectric film.

The present invention can be carried out as described above, yet the present invention can be carried out while employing configurations other than the above configurations as long as these configurations correspond to the claims. For example, the vibrating device according to the present invention may be used for other devices than the tactile sense presenting device such as a flat speaker.

### Description Of Reference Symbols

10: TACTILE SENSE PRESENTING DEVICE
11: CONTROL UNIT
12: DRIVING UNIT
20, 20B, 20C: VIBRATING DEVICE
21, 21B, 21C: DIAPHRAGM
22, 22B, 22C: PIEZOELECTRIC FILM
23, 23A, 23B, 23C, 24C: SPACER
24: FIXED END
24B, 25C: FIXED PORTION
25: BASE PORTION
26: PROTRUSION PORTION
30: TOUCH PANEL
31: TOUCH SENSOR

## Claims

1. A vibrating device (20) comprising:
a diaphragm (21) which is configured to warp in a thickness direction; and
a film (22), part of which has a property that causes vibration in a planar direction of the film when electrically driven, which is connected to a first end of the diaphragm (21) at a first connection position and to a second opposing end of the diaphragm (21) at a second connection position, and which is stretched in a direction crossing the diaphragm from the first connection position to the second connection position, wherein the planar vibration of the film causes the warping in a thickness direction of the diaphragm;
**characterised in that** the vibrating device further comprises:
a spacer (23), positioned between the diaphragm (21) and the film (22), which is configured to secure a gap between the diaphragm (21) and the film (22) at a position apart from the first and second connection positions.

2. The vibrating device of claim 1, wherein the film (22) is connected to the second opposing end of the diaphragm (21) via a support member.

3. The vibrating device of any preceding claim, wherein the first connection position is located in the vicinity of the first end of the diaphragm (21) and the second connection position is located in the vicinity of the second opposing end of the diaphragm (21).

4. The vibrating device according any preceding claim wherein the spacer (23) is in contact with the diaphragm (21) and the film (22) at all times.

5. The vibrating device according to any preceding claim, wherein the spacer (23) includes
a base portion which is provided at a side of the film, and
a plurality of protrusion portions which is provided at a side of the diaphragm and protrudes in the thickness direction from the base portion.

6. The vibrating device according any preceding claim wherein the spacer (23) is provided at or near the center of the vibrating device in a length direction orthogonal to the thickness direction.

7. The vibrating device according to any of claims 1 to 5, wherein a plurality of the spacers (23) is aligned in a length direction orthogonal to the thickness direction.

8. The vibrating device according any preceding claim wherein a contact position of the spacer (23) on the diaphragm (21) is configured to serve as a node of vibration of the diaphragm.

9. The vibrating device according to any preceding claim, wherein the diaphragm (21) has a flat shape in a state where the film does not cause an inverse piezoelectric effect.

10. The vibrating device of any preceding claim, wherein the film is a piezoelectric film, a composite film or an electroactive film.

11. The vibrating device according to any of claims 1 to 9, wherein the film includes a chiral polymer film or a polyvinylidene fluoride film.

12. A tactile sense presenting device (10) comprising:
a vibrating device (20) according to any one of claims 1 to 11;
a touch detecting unit (30) which is attached to the diaphragm and is configured to detect a touch operation; and
a control unit (11) which, when the touch detecting unit detects the touch operation, is configured to apply a drive voltage to the film.

## Patentansprüche

1. Vibrierende Vorrichtung (20), die Folgendes umfasst:
eine Membran (21), die so konfiguriert ist, dass sie sich in einer Dickenrichtung verformt; und
eine Folie (22), von der ein Teil eine Eigenschaft aufweist, die bei elektrischem Antrieb eine Vibration in einer planaren Richtung der Folie verursacht, die mit einem ersten Ende der Membran (21) an einer ersten Verbindungsposition und mit einem zweiten, gegenüberliegenden Ende der Membran (21) an einer zweiten Verbindungsposition verbunden ist und die in einer Richtung gedehnt wird, die die Membran von der ersten Verbindungsposition zur zweiten Verbindungsposition überquert, wobei die planare Vibration der Folie die Verformung in einer Dickenrichtung der Membran verursacht;
**dadurch gekennzeichnet, dass** die vibrierende Vorrichtung ferner Folgendes umfasst:
einen zwischen der Membran (21) und der Folie (22) positionierten Abstandshalter (23), der zum Sichern eines Spalts zwischen der Membran (21) und der Folie (22) an einer Position abseits der ersten und zweiten Verbindungsposition konfiguriert ist.

2. Vibrierende Vorrichtung nach Anspruch 1, wobei die Folie (22) mit dem zweiten, gegenüberliegenden Ende der Membran (21) über ein Stützelement verbunden ist.

3. Vibrierende Vorrichtung nach einem vorherigen Anspruch, wobei sich die erste Verbindungsposition in der Nähe des ersten Endes der Membran (21) und die zweite Verbindungsposition in der Nähe des zweiten, gegenüberliegenden Endes der Membran (21) befindet.

4. Vibrierende Vorrichtung nach einem vorherigen Anspruch, wobei der Abstandshalter (23) ständig mit der Membran (21) und der Folie (22) in Kontakt ist.

5. Vibrierende Vorrichtung nach einem vorherigen Anspruch, wobei der Abstandshalter (23) einen Basisabschnitt aufweist, der an einer Seite der Folie vorgesehen ist, und
mehrere Vorsprungsabschnitte, die an einer Seite der Membran vorgesehen sind und in Dickenrichtung vom Basisabschnitt vorstehen.

6. Vibrierende Vorrichtung nach einem vorherigen Anspruch, wobei der Abstandshalter (23) an oder nahe der Mitte der vibrierenden Vorrichtung in einer Längenrichtung orthogonal zur Dickenrichtung vorgesehen ist.

7. Vibrierende Vorrichtung nach einem der Ansprüche 1 bis 5, wobei mehrere Abstandshalter (23) in einer Längenrichtung orthogonal zur Dickenrichtung ausgerichtet sind.

8. Vibrierende Vorrichtung nach einem vorherigen Anspruch, wobei eine Kontaktposition des Abstandshalters (23) auf der Membran (21) so konfiguriert ist, dass sie als ein Vibrationsknotenpunkt der Membran dient.

9. Vibrierende Vorrichtung nach einem vorherigen Anspruch, wobei die Membran (21) in einem Zustand, in dem die Folie keinen inversen piezoelektrischen Effekt verursacht, eine flache Form aufweist.

10. Vibrierende Vorrichtung nach einem vorherigen Anspruch, wobei die Folie eine piezoelektrische Folie, eine Verbundfolie oder eine elektroaktive Folie ist.

11. Vibrierende Vorrichtung nach einem der Ansprüche 1 bis 9, wobei die Folie eine chirale Polymerfolie oder eine Polyvinylidenfluoridfolie enthält.

12. Tastsinnpräsentiervorrichtung (10), die Folgendes umfasst:
eine vibrierende Vorrichtung (20) nach einem der Ansprüche 1 bis 11;
eine Berührungserkennungseinheit (30), die an der Membran angebracht und zum Erkennen einer Berührungsbetätigung konfiguriert ist; und
eine Steuereinheit (11), die, wenn die Berührungserkennungseinheit die Berührungsbetätigung erkennt, zum Anlegen einer Ansteuerspannung an die Folie konfiguriert ist.

## Revendications

1. Dispositif vibrant (20) comprenant :
un diaphragme (21) configuré pour se déformer dans une direction d'épaisseur ; et
un film (22), dont une partie a une propriété qui provoque une vibration dans une direction plane du film lorsqu'il est excité électriquement, lequel est connecté à une première extrémité du diaphragme (21) à une première position de connexion et à une seconde extrémité opposée du diaphragme (21) à une seconde position de connexion, et lequel est étiré dans une direction traversant le diaphragme de la première position de connexion à la seconde position de connexion, dans lequel la vibration plane du film provoque la déformation dans une direction d'épaisseur du diaphragme ;
**caractérisé en ce que** le dispositif vibrant comprend en outre :
une entretoise (23), positionnée entre le diaphragme (21) et le film (22), laquelle est configurée pour assurer un espace entre le diaphragme (21) et le film (22) à une position écartée des première et seconde positions de connexion.

2. Dispositif vibrant selon la revendication 1, dans lequel le film (22) est connecté à la seconde extrémité opposée du diaphragme (21) par l'intermédiaire d'un élément de support.

3. Dispositif vibrant selon n'importe quelle revendication précédente, dans lequel la première position de connexion est située à proximité de la première extrémité du diaphragme (21) et la seconde position de connexion est située à proximité de la seconde extrémité opposée du diaphragme (21).

4. Dispositif vibrant selon n'importe quelle revendication précédente dans lequel l'entretoise (23) est en contact permanent avec le diaphragme (21) et le film (22).

5. Dispositif vibrant selon n'importe quelle revendication précédente, dans lequel l'entretoise (23) comporte
une partie de base fournie sur un côté du film, et
une pluralité de parties saillantes fournie sur un côté du diaphragme et dépassant dans la direction d'épaisseur de la partie de base.

6. Dispositif vibrant selon n'importe quelle revendication précédente dans lequel l'entretoise (23) est fournie au centre ou à proximité du centre du dispositif vibrant dans une direction de longueur orthogonale à la direction d'épaisseur.

7. Dispositif vibrant selon l'une quelconque des revendications 1 à 5, dans lequel une pluralité d'entretoises (23) est alignée dans une direction de longueur orthogonale à la direction d'épaisseur.

8. Dispositif vibrant selon n'importe quelle revendication précédente dans lequel une position de contact de l'entretoise (23) sur le diaphragme (21) est configurée pour servir de nœud de vibration du diaphragme.

9. Dispositif vibrant selon n'importe quelle revendication précédente, dans lequel le diaphragme (21) a une forme plate dans un état où le film ne provoque pas d'effet piézoélectrique inverse.

10. Dispositif vibrant selon n'importe quelle revendication précédente, dans lequel le film est un film piézoélectrique, un film composite ou film électroactif.

11. Dispositif vibrant selon l'une quelconque des revendications 1 à 9, dans lequel le film comprend un film polymère chiral ou un film de fluorure de polyvinylidène.

12. Dispositif de présentation tactile (10) comprenant :
un dispositif vibrant (20) selon l'une quelconque des revendications 1 à 11 ;
une unité de détection tactile (30) fixée au diaphragme et configurée pour détecter une opération tactile ; et
une unité de commande (11) qui, lorsque l'unité de détection tactile détecte l'opération tactile, est configurée pour appliquer une tension d'excitation au film.
